# EUROPEAN PATENT APPLICATION

(11) **EP 4 220 571 A1**
(43) Date of publication of application: **02.08.2023**
(21) Application number: 23153550.1
(22) Date of filing: 26.01.2023
(51) Int. Cl.: G06T 17/20, G06F 30/20

(54) **GEOMETRICAL CALCULATIONS FOR TARGETED LOCAL FEM MESH REFINEMENT IN FINISH TURNING SYSTEMS AND METHODS**

(30) Priority: 28.01.2022 US 202263304430 P
(71) Applicant: Raytheon Technologies Corporation, Farmington, CT 06032 (US)
(72) Inventor: KOUNTANYA, Raja Krishnan, Vernon (US); THOMAS, Jean-Philippe Albert, Wethersfield (US); GRAM, Michael, Henderson (US)
(74) Representative: Dehns

(57) **Abstract**

Systems and methods for mesh refinement of finite element analysis simulations employ an analytical modeling program configured to identify a location of contact (614) between two components and a finite element analysis program configured to use the identified location to perform finite element mesh refinement. In this regard, the location of contact (614) (and location of desired mesh refinement) is identified using analytical modeling. Said location of contact (614) is then provided to the finite element analysis program for determining precisely where to perform mesh refinement on the finite element mesh. The finite element analysis program performs a mesh refinement at the exact location of contact (614) between two components to provide for optimized and more efficient finite element analysis.

## Description

### TECHNICAL FIELD

The present disclosure relates generally to finite element analysis, and more particularly to systems and methods for mesh refinement for finite element analysis.

### BACKGROUND

Standard FEM (finite element method) platforms such as ABAQUS, ANSYS, etc. are greatly challenged when applied in machining modeling owing to occurrence of multiple length scales, high strains, high strain rates, high temperatures, and gradients thereof. In general, as relative length scale decreases, resolution of numerical solution increases (i.e., becomes finer and more accurate) and the cost (e.g., computing power and/or duration) to numerically solve the equations increases. Conversely, as length scale increases, resolution and cost decreases. Therefore, it is desirable to balance the cost with the resolution, and consequentially the accuracy, of the numerical solution.

### SUMMARY

According to an aspect of the invention, a method for mesh refinement of finite element analysis simulations is disclosed, the method comprising the steps of a) identifying a surface location of a first model based on attribute data of a tool which directly contacts a workpiece model during a machining process simulation using an analytical modeling module, b) mapping the surface location of the tool to a second model based on the first model, the second model comprising an external finite element mesh, and c) performing a mesh refinement on the external finite element mesh of the second model at the surface location of the tool using a finite element method module to generate a refined finite element mesh.

In various embodiments, the first model may be provided using the analytical modeling module.

In various embodiments, the external finite element mesh delineates an external geometry of a solid model based on the tool.

In various embodiments, the method further comprises processing the second model using finite element analysis and the refined finite element mesh.

In various embodiments, the first model is further based on topography data of the tool.

In various embodiments, the surface location of the tool which directly contacts the workpiece is identified using analytical modeling.

In various embodiments, the tool is a cutting insert and the surface location is a fraction of a corner radius of the cutting insert responsible for generating a finished surface of the workpiece.

In various embodiments, the surface location is a portion of the tool surface responsible for generating a finished surface of the workpiece.

In various embodiments, the first model is provided by generating the first model with the analytical modeling module based on a topography data of the tool, wherein the topography data comprises data generated using microscopy and 3D reconstruction.

According to an aspect of the invention, a computer system for mesh refinement of finite element analysis simulations is disclosed, the system comprising an analytical modeling module and a finite element method module. The analytical modeling module is for processing an analytical model based on attribute data of a tool, the analytical modeling module configured to identify a surface location of the tool which directly contacts a workpiece. The finite element method module is for processing a finite element model based on attribute data of the tool, the finite element model comprising an external finite element mesh, the finite element method module configured to map the surface location of the tool to the external finite element mesh, and further configured to perform a mesh refinement on the external finite element mesh at the surface location of the tool.

In various embodiments, mapping the surface location of the tool comprises placement of a mesh refinement window at the identified surface location of the tool.

In various embodiments, the mesh refinement window delineates the identified surface location of the tool.

In various embodiments, the analytical modeling is configured to receive topography data of the tool.

In various embodiments, the analytical modeling module is configured to generate the analytical model based on the topography data.

In various embodiments, the topography data comprises data generated using microscopy.

In various embodiments, the computer system further comprises a display device configured to display the finite element model.

According to a further aspect of the invention, a method is disclosed, comprising measuring a topography of a tool, generating a first model based on the topography of the tool, identifying a surface location of the first model which directly contacts a workpiece, mapping the surface location of the tool to a second model of the tool, the second model comprising an external finite element mesh, and performing a mesh refinement on the external finite element mesh of the second model at the surface location of the tool.

In various embodiments, the topography is measured using microscopy.

In various embodiments, the tool is a cutting insert and the surface location is a fraction of a corner radius of the cutting insert responsible for generating a finished surface of the workpiece.

In various embodiments, the mesh refinement is performed using a finite element mesh generator.

In various embodiments, the method further comprises processing the second model using finite element analysis.

The foregoing features and elements may be combined in various combinations without exclusivity, unless expressly indicated otherwise. These features and elements as well as the operation thereof will become more apparent in light of the following description and the accompanying drawings. It should be understood, however, the following description and drawings are intended to be exemplary in nature and nonlimiting.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.
FIG. 1 is a system block diagram schematically illustrating of an embodiment of a computer system architecture, according to various embodiments;
FIG. 2 is a flow chart illustrating a method for mesh refinement of finite element analysis simulations, according to various embodiments;
FIG. 3 is a flow chart illustrating a method for mesh refinement of finite element analysis simulations, according to various embodiments;
FIG. 4 is an exemplary analytical model of a cutting insert tool with respect to XYZ-axes, according to various embodiments;
FIG. 5 is an exemplary finite element model including a finite element mesh of a cutting insert tool and a finite element mesh of a workpiece, according to various embodiments;
FIG. 6A is an exemplary finite element model including a finite element mesh of a cutting insert tool and a finite element mesh of a workpiece, according to various embodiments;
FIG. 6B is the exemplary finite element models of FIG. 6A with mesh refinement windows located at the location(s) of contact between the tool and the workpiece, according to various embodiments; and
FIG. 6C is the exemplary finite element models of FIG. 6A with refined finite element meshes, according to various embodiments.

### DETAILED DESCRIPTION

The detailed description of exemplary embodiments herein makes reference to the accompanying drawings, which show exemplary embodiments by way of illustration and their best mode. While these exemplary embodiments are described in sufficient detail to enable those skilled in the art to practice the inventions, it should be understood that other embodiments may be realized and that logical, chemical and mechanical changes may be made without departing from the spirit and scope of the disclosure. Thus, the detailed description herein is presented for purposes of illustration only and not of limitation. For example, the steps recited in any of the method or process descriptions may be executed in any order and are not necessarily limited to the order presented.

Furthermore, any reference to singular includes plural embodiments, and any reference to more than one component or step may include a singular embodiment or step. Also, any reference to attached, fixed, connected or the like may include permanent, removable, temporary, partial, full and/or any other possible attachment option. Additionally, any reference to without contact (or similar phrases) may also include reduced contact or minimal contact.

As used herein, phrases such as "make contact with," "coupled to," "touch," "interface with" and "engage" may be used interchangeably. Different cross-hatching is used throughout the figures to denote different parts but not necessarily to denote the same or different materials.

Application of standard FEM (finite element method) platforms such as ABAQUS, ANSYS, etc. is greatly burdened in machining modeling owing to occurrence of multiple length-scales, high strains, high strain rates, high temperatures, and gradients thereof. The length-scale problem is particularly important if FEM is to be used as a diagnostic tool to rectify part quality problems, for example in finish turning, since only a very small part of the cutting edge is responsible to produce the finished surface. Typically, the user applies a mesh window at an appropriate location to alleviate the length scale problem to refine the mesh, i.e., to make the mesh finer. However, the precise location to apply one is not known beforehand. Therefore, the user redundantly makes the mesh finer over a larger volume than is beneficial. This arbitrariness in mesh refinement slows down the FEM simulation.

Systems and methods of the present disclosure provide the user with the precise location to apply a mesh refinement window. In this regard, the user applies an optimal mesh window knowing beforehand the portion of the edge in engagement with the finished part. A formal rigorous geometrical model allows calculation of the extents of this portion numerically to arbitrary precision. The geometrical model uses information from reconstruction of an insert using microscopy and reverse engineering platforms. The approach may also use flow-stress, friction, and damage models which have been proven in 2D simulations and experiments.

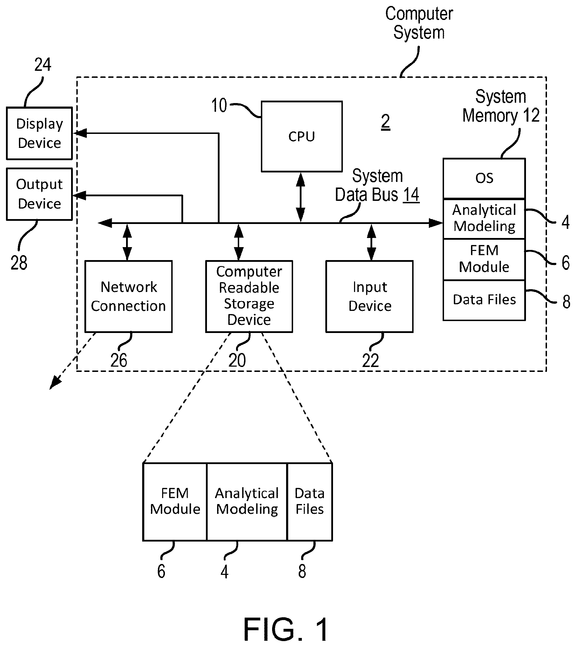

Referring to FIG. 1 through FIG. 3, an integrated computer system 2 and method for mesh refinement for FEM analysis is illustrated. An overview of an exemplary computer system architecture 2 for analytical modeling and FEM analysis is illustrated schematically in FIG. 1. Computer system 2 comprises several software or program procedural components that execute program instructions for specific purposes. The program procedural components includes some or all of the following modules-an analytical modeling module 4 and a finite element method (FEM) module 6.

A brief overview of the function of each module is described below. Analytical modeling module 4 generates a three-dimensional solid model of a cutting tool or other device to be analyzed and a workpiece. FEM module 6 (also referred to as finite element analysis module or simulator system) performs numerical calculations to simulate the environment of a cutting tool with respect to a workpiece for predicting a physical response-including but not limited to flow-stress, friction, and damage models-to the cutting surface geometry. An operating system of computer system 2, may include variations of the standard system such as UNIX^{®}, WINDOWS^{®}, LINUX^{®}, or any other suitable operating system. Each component of computer system 2 will be described in detail herein.

Shown schematically in FIG. 1, computer system 2 may a high-speed computer workstation, a personal computer, a laptop computer, or any other suitable computer. In various embodiments, computer system 2 includes one or more controllers (e.g., processors) and one or more tangible, non-transitory memories capable of implementing digital or programmatic logic. In various embodiments, for example, the one or more controllers are one or more of a general purpose processor, digital signal processor (DSP), application specific integrated circuit (ASIC), field programmable gate array (FPGA), or other programmable logic device, discrete gate, transistor logic, or discrete hardware components, or any various combinations thereof or the like. System program instructions and/or controller instructions may be loaded onto a non-transitory, tangible computer-readable medium having instructions stored thereon that, in response to execution by a controller, cause the controller to perform various operations. The term "non-transitory" is to be understood to remove only propagating transitory signals per se from the claim scope and does not relinquish rights to all standard computer-readable media that are not only propagating transitory signals per se. Stated another way, the meaning of the term "non-transitory computer-readable medium" and "non-transitory computer-readable storage medium" should be construed to exclude only those types of transitory computer-readable media which were found in *In Re Nuijten* to fall outside the scope of patentable subject matter under 35 U.S.C. 9 101.

Hardware components of computer system 2 include a central processing unit 10, a system memory 12, and a system bus 14 that couples various computer system components. Central processing unit 10 may be one or more suitable general-purpose processors or the like. The system bus 14 may be any of several types of conventional bus structures. System memory 12 may include computer readable code in the form of read only and random access memory. System memory 12 is used to store a portion of analytical modeling module 4, FEM module 6, and/or related data files 8.

Computer system 2 further includes a computer readable storage device 20 that may comprise a hard disk drive, a magnetic disk drive, an optical disk drive such as a Compact Disk ROM, a DVD drive, or any other suitable computer readable storage device. Storage device 20 and associated computer-readable media provide nonvolatile storage of computer readable code and instructions for execution on the computer system. Analytical modeling module 4, FEM module 6, and related data files 8 may be stored on storage device 20.

If desired, a user may enter commands and information into computer system 2 through an input device 22 such as a keyboard, a mouse, a pointing device, a graphics tablet, a touch screen, or any other suitable input device. A display device 24, such as a monitor may also be connected to the system bus by conventional methods. In addition to the monitor, computer system can 2 include other peripheral output devices 28, such as a printer.

If desired, computer system 2 may operate in a networked environment using a network connection 26 to one or more destination clients such as a computer workstation or a network server. The networked environment may include a local area network (LAN), a wide area network (WAN), or a distributed network, such as a packet switched network, for example a network implementing TCP/IP such as the Internet, including the World Wide Web, among other networked environments.

Component attribute data is herein defined as a specific set of data elements that defines a three- or two-dimensional representation of the geometry of a particular object. The term "cutting tool" attribute data comprises component attribute data as applied to a cutting tool. Component attribute data may comprise positional, dimensional, and/or material property data. The positional and dimensional data may comprise information relating to physical measurements relative to user specified Cartesian coordinate system of x, y, z-axes or directions, vectors, surface, and/or curve definitions.

Referring to FIG. 1, computer system 2, includes analytical modeling module 4 having hardware and software for providing dimensional and material characteristics of a cutting tool or other parts. In the embodiment shown, analytical modeling module 4 creates a set of cutting tool attribute data for use in FEM module 6. The cutting tool attribute data may be processed so that a representation can be illustrated in a three-dimensional model, commonly called a solid model. Analytical modeling module 4 may embody the cutting tool attribute data in a computer readable code that can be stored on a nonvolatile computer useable storage medium, such as storage device 20. The analytical modeling module 4 may be embodied by a system running computer-aided-design or engineering (CAD/CAE) and/or computer-aided-manufacturing (CAM) software that produces an IGES compatible format or any suitable data format for transmitting solid model definitions across different types of CAD/CAM/CAE systems. Nevertheless, suitable alternatives of the graphics module include, UNIGRAPHICS^{®} software manufactured by UGS, INC. of Cypress Calif., and AUTOCAD^{®} by Autodesk, Inc., or other alternative software.

A simulator system such as FEM module 6 includes hardware and software configured to generate a finite element mesh and perform numerical computations using a finite element analysis method. FEM module 6 receives the cutting tool attribute data from analytical modeling module 4 or other source storing the data. The finite element mesh includes finite element units that interconnect at nodes. The finite element mesh is embodied in a computer readable code that can be stored in computer readable code in devices such as storage device 20 or system memory 12. FEM module 6 predicts physical performance parameters or characteristics from a cutting tool simulation of an analytical model, being dynamically configurable, having a specific set of boundary conditions applied to the nodes of the finite element mesh.

FEM module 6 advantageously implements an algorithm to refine the finite element mesh for the external geometry of the cutting tool under evaluation. If desired, a separate finite element mesh generator can execute the algorithm for mesh refinement code. The algorithm enables the mesh size (i.e., the distance between nodes) of the cutting tool and/or the workpiece to be varied based upon a precise location of contact between the cutting tool and the workpiece as determined by analytical modeling module 4 so that optimally fine mesh (also referred to as small length-scale meshing) is located at or near the interface of the cutting tool and the workpiece and larger length-scale meshing is used at other locations where fine mesh would be unnecessarily costly when iteratively calculating a numeral solution. In contrast to conventional methods, the present disclosure advantageously enables intelligent precise placement of mesh refinement windows for finish turning simulations by combining an analytical modeling software (i.e., analytical modeling module 4) to locate the precise cutting surfaces of the cutting tool and feeding these locations to the finite element analysis software (i.e., FEM module 6). Accordingly, the present disclosure significantly reduces the associated processing time and cost over conventional systems. In contrast, conventional systems tend to redundantly make the mesh finer over a larger volume than desired and slows down the FEM simulation.

Finite element analysis module 6 may be embodied by a computer system running an appropriate finite element simulation software having structural and/or thermal analysis capability such as, ANSYS^{®} manufactured by Ansys, Inc, ABAQUS^{®}, by Hibbitt, Karlsson & Sorensen, Inc., Pawtucket, R.I., or other similar type of systems.

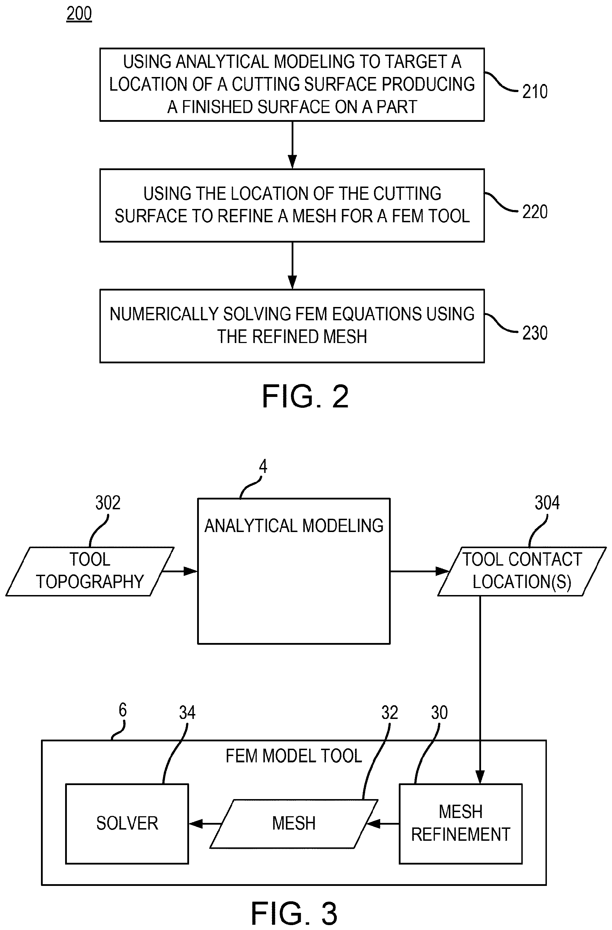

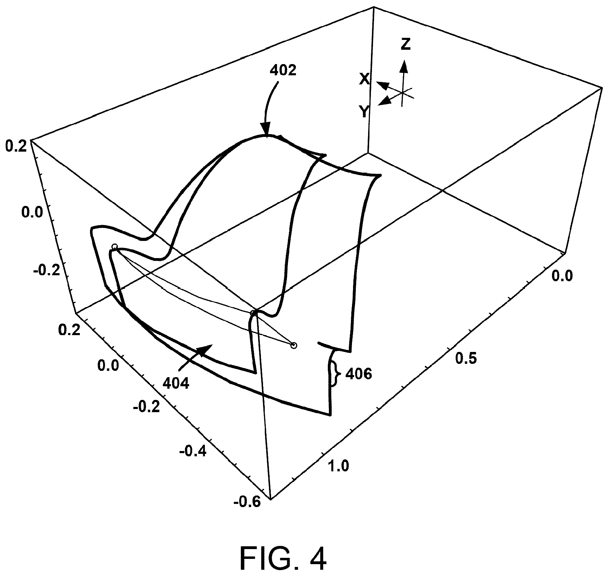

FIG. 2 and FIG. 3 illustrate flow charts of an embodiment of a method 200 implemented by computer system 2 for mesh refinement of finish turning simulations. In step 210, a surface location of a tool that makes contact with a workpiece during finish turning is located to determine at which portion of the tool it is desirable to decrease length-scale of a finite element mesh during finite element analysis. With momentary reference to FIG. 4, an exemplary solid model 402 (also referred to herein as a first model) of a tool is provided which has a cutting surface 404 configured to cut into a workpiece (e.g., for generating a finished surface of the workpiece). Although described herein with respect to a cutting insert, the systems and methods of the present disclosure may be performed in various applications other than cutting tool simulations without departing from the scope of the present disclosure. Step 210 may include identifying a portion of the cutting surface 404 that makes contact with the workpiece. In various embodiments, step 210 includes solving numerically the extents with rigorous differential geometry formulation of the tool insert surface. In various embodiments, where the tool is a cutting insert having a rounded corner (i.e., a corner radius), step 210 includes identifying a portion of a corner radius (e.g., portion 406) of the cutting surface 404 that makes contact with the workpiece. The identified portion including tool surface contact location(s) 304 may be stored as data comprising information relating to physical measurements relative to user specified Cartesian coordinate system of x, y, z-axes or directions, vectors, surface, and/or curve definitions. In various embodiments, various aspects of step 210 are performed using analytical modeling module 4.

In various embodiments, the solid model 402 of the tool is generated in step 210. In various embodiments, solid model 402 is generated using cutting tool attribute data provided to the analytical modeling module 4. In various embodiments, solid model 402 is generated using cutting tool topography data provided to the analytical modeling module 4. With momentary focus on FIG. 3, the solid model 402 may be generated using tool topography 302. Tool topography 302 may comprise the topography of a work surface (e.g., a cutting surface) of the tool to be analyzed. In this regard, step 210 may include measuring a topography of the tool to be analyzed. The topography may be measured by taking a picture of the tool using microscopy methods (e.g., optical scanning, white-light interferometric scanning, pneumatic topographical measurements, laser topographical measurements, etc.). The tool topographical data 302 may be stored as data comprising information relating to physical measurements relative to user specified Cartesian coordinate system of x, y, z-axes or directions, vectors, surface, coefficients, and/or curve definitions.

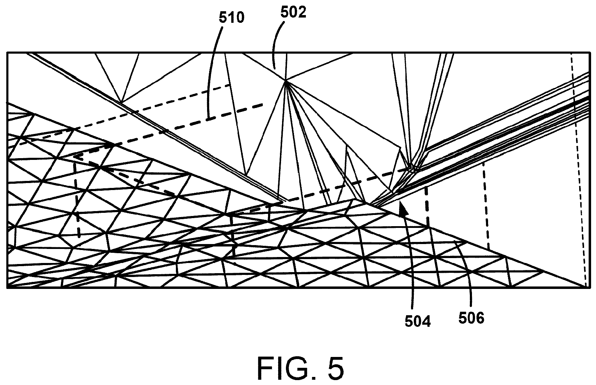

Method 200 further includes using the identified location(s) of the tool to refine a finite element mesh used by FEM module 6 (step 220). In this regard, step 220 may include sending tool surface contact location(s) 304 to FEM module 6. Computer system 2 (see FIG. 1) may request the analytical modeling module 4 to transmit the tool surface contact location(s) 304 to the FEM module 6. FEM module 6 may include a finite element mesh generator 30 configured to refine the finite element mesh based upon the received tool surface contact location(s) 304. In various embodiments, the finite element mesh is an external finite element mesh. With momentary reference to FIG. 5, an exemplary finite element model 502 (also referred to herein as a second model) of the tool is provided which has a cutting surface 504 configured to cut into a workpiece 506 (e.g., for generating a finished surface of the workpiece). Finite element model 502 may comprise a finite element mesh delineating an outer geometry of a tool to be analyzed. Finite element mesh generator 30 may be configured to place a mesh refinement window 510 to mark a location for reducing a length-scale of the finite element mesh of finite element model 502 and/or workpiece 506. Mesh refinement window 510 may delineate the identified location of contact between the tool and the workpiece. In this manner, intelligent precise placement of a mesh refinement window 510 for a finish turning simulation is enabled using the tool surface contact location(s) 304. If desired, the mesh refinement window 510 may be placed so that the mesh is refined only at the location of contact between the tool and the workpiece. However, the mesh refinement window 510 may be sized to include the interface between the tool and the workpiece and a predetermined proximity from the interface, as desired. Moreover, a plurality of refinement windows 510 may be nested within each other to provide a successively decreasing length-scale which is the smallest at the interface and increases with distance from the interface, as desired, to capture small length-scale phenomena. The finite element mesh generator 30 may output the refined mesh 32 to a finite element solver 34 (also referred to herein as a simulation module) for executing a simulation of a finish turning process with the tool and the workpiece. The simulation is optimized using the systems and methods of the present disclosure by locating a refined mesh where desired without redundantly making the mesh finer over a larger volume than necessary which would unnecessarily slows down the FEM simulation.

Method 200 may include numerically solving a set of equations (typically constrained by boundary conditions) using the refined mesh 32 (Step 230). In this regard, solver 34 may analyze the mesh with a set of equations and boundary conditions by the finite element method.

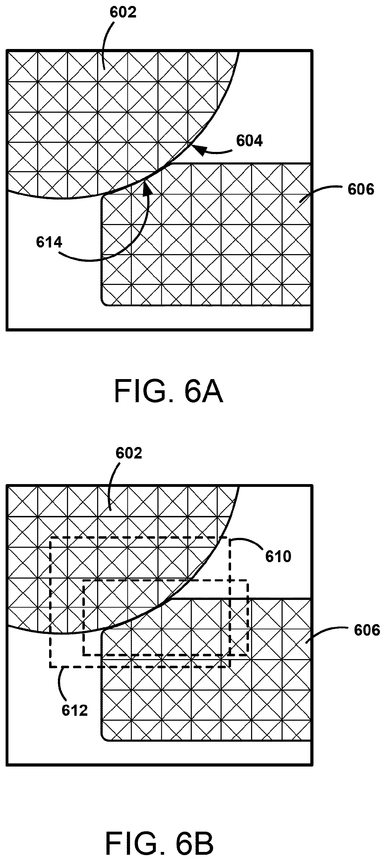

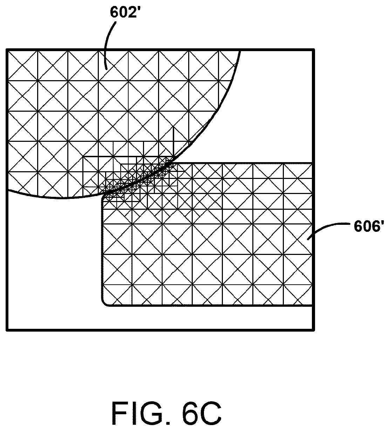

With reference to FIG. 6A through FIG. 6C, an exemplary finite element model 602 (also referred to herein as a second model) of a tool is provided which has a cutting surface 604 configured to cut into a workpiece 606 (e.g., for generating a finished surface of the workpiece). FIG. 6A through FIG. 6C illustrate a side view of the finite element model for simplicity, though it should be understood that the systems and methods described with respect to FIG. 6A through FIG. 6C apply to 3D models (e.g., similar to FIG. 5). Finite element model 602 may comprise a finite element mesh delineating an outer geometry of a tool to be analyzed. With combine reference to FIG. 3 and FIG. 6A through FIG. 6C, finite element mesh generator 30 may be configured to place a mesh refinement window 610 to mark a location for reducing a length-scale of the finite element mesh of finite element model 602. Finite element mesh generator 30 may be configured to place a mesh refinement window 612 to mark a location for reducing a length-scale of the finite element mesh of workpiece 606. Mesh refinement window 610 may delineate the identified location of contact 614 between the tool and the workpiece. In this manner, intelligent precise placement of a mesh refinement window 610 and/or mesh refinement window 612 for a finish turning simulation is enabled using the tool surface contact location(s) 304. The finite element mesh generator 30 may output the refined mesh 32 (see refined finite element mesh 602' and refined finite element mesh 606' of FIG. 6C) to a finite element solver 34 (also referred to herein as a simulation module) for executing a simulation of a finish turning process with the tool and the workpiece. Method 200 may include numerically solving a set of equations (typically constrained by boundary conditions) using the refined mesh(es) 32 (see refined finite element mesh 602' and refined finite element mesh 606' of FIG. 6C) (Step 230). In this regard, solver 34 may analyze the mesh(es) with a set of equations and boundary conditions by the finite element method.

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the inventions. The scope of the disclosure is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, Band C may be present in a single embodiment; for example, A and B, A and C, B and C, or A and B and C.

Systems, methods and apparatus are provided herein. In the detailed description herein, references to "one embodiment", "an embodiment", "various embodiments", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

Furthermore, no element, component, or method step in the present disclosure is intended to be dedicated to the public regardless of whether the element, component, or method step is explicitly recited in the claims. No claim element herein is intended to invoke 35 U.S.C. 112(f), unless the element is expressly recited using the phrase "means for." As used herein, the terms "comprises", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for mesh refinement of finite element analysis simulations, the method comprising the steps of:
identifying, by a controller, a surface location of a first model based on attribute data of a tool which directly contacts a workpiece during a machining process using an analytical modeling module;
mapping, by the controller, the surface location of the tool to a second model based on the first model, the second model comprising an external finite element mesh; and
performing, by the controller, a mesh refinement on the external finite element mesh of the second model at the surface location of the tool using a finite element method module to generate a refined finite element mesh.

2. The method according to claim 1, wherein the external finite element mesh delineates an external geometry of a solid model based on the tool.

3. The method according to claim 1 or 2, further comprising processing, by the controller, the second model using finite element analysis and the refined finite element mesh.

4. The method according to claim 1, 2 or 3, wherein the first model is further based on topography data of the tool.

5. The method according to any preceding claim, wherein the surface location of the tool which directly contacts the workpiece is identified using analytical modeling.

6. The method according to any preceding claim, wherein the tool is a cutting insert and the surface location is a fraction of a corner radius of the cutting insert responsible for generating a finished surface of the workpiece.

7. The method according to any preceding claim, wherein the surface location is a portion of the tool surface responsible for generating a finished surface of the workpiece.

8. The method according to any preceding claim, wherein the first model is provided by generating the first model with the analytical modeling module based on a topography data of the tool, wherein the topography data comprises data generated using microscopy.

9. A computer system for mesh refinement of finite element analysis simulations, the system comprising:
an analytical modeling module for processing an analytical model based on attribute data of a tool, the analytical modeling module configured to identify a surface location of the tool which directly contacts a workpiece; and
a finite element method module for processing a finite element model based on attribute data of the tool, the finite element model comprising an external finite element mesh, the finite element method module configured to map the surface location of the tool to the external finite element mesh, and further configured to perform a mesh refinement on the external finite element mesh at the surface location of the tool.

10. The computer system of claim 9, wherein mapping the surface location of the tool comprises placement of a mesh refinement window at the identified surface location of the tool; and wherein, optionally, the mesh refinement window delineates the identified surface location of the tool.

11. The computer system of claim 9 or 10, wherein the analytical modeling is configured to receive topography data of the tool.

12. The computer system of claim 11, wherein the analytical modeling module is configured to generate the analytical model based on the topography data; and wherein, optionally, the topography data comprises data generated using microscopy.

13. The computer system of any of claim 9 to 12, wherein the computer system further comprises a display device configured to display the finite element model.

14. A method comprising:
measuring a topography of a tool;
generating a first model based on the topography of the tool;
identifying a surface location of the first model which directly contacts a workpiece;
mapping the surface location of the tool to a second model of the tool, the second model comprising an external finite element mesh; and
performing a mesh refinement on the external finite element mesh of the second model at the surface location of the tool.

15. The method according to claim 14, wherein the topography is measured using microscopy; and/or
wherein the tool is a cutting insert and the surface location is a fraction of a corner radius of the cutting insert responsible for generating a finished surface of the workpiece; and/or
wherein the mesh refinement is performed using a finite element mesh generator; and/or
wherein the method further comprises processing the second model using finite element analysis.
